# EUROPEAN PATENT SPECIFICATION

(11) **EP 3 379 569 B1**
(45) Date of publication and mention of the grant of the patent: **11.05.2022**
(21) Application number: 17162160.0
(22) Date of filing: 21.03.2017
(51) Int. Cl.: H01L 21/673

(54) **APPARATUS FOR CARRYING AND SHIELDING WAFERS**
VORRICHTUNG ZUM TRAGEN UND ZUM ABSCHIRMEN VON WAFERN
APPAREIL POUR TRANSPORTER ET PROTÉGER DES PLAQUETTES

(43) Date of publication of application: 26.09.2018
(73) Proprietor: Himax Technologies Limited, Tainan City 74148 (TW)
(72) Inventor: CHANG, Jui Tang, 74148 Tainan City (TW)
(74) Representative: Karakatsanis, Georgios

(56) References cited:
- WO-A1-2014/189739
- JP-B2- 2 908 161
- JP-B2- 5 967 919

## Description

### BACKGROUND OF THE INVENTION

### 1. FIELD OF THE INVENTION

The present invention generally relates to wafer cassettes, and more particularly to apparatus for carrying and shielding wafers.

### 2. DESCRIPTION OF RELATED ART

A wafer cassette is a device that is capable of holding wafers to allow the wafers to be transferred between machines for processing or measurement. The wafers stored in the wafer cassette may be taken out of or be placed into the wafer cassette by a robotic hand or fork.

The purpose of Standard Mechanical InterFace (SMIF) pods is to isolate wafers from contamination by providing a miniature environment with controlled airflow, pressure and particle count. SMIF pods can be accessed by a robotic arm of a robot system. Front Opening Unified Pod (FOUP) is another enclosure standard designed to hold wafers securely and safely in a controlled environment, and to allow the wafers to be transferred between machines for processing or measurement.

For efficiency, more than one wafer cassettes are usually disposed in conventional pods or enclosures. Nevertheless, as the wafer cassettes are individually placed in the pod or enclosure, the conventional pod or enclosure suffers from low operational precision when the wafers are accessed by the robotic arm of the robot system.

In order to prevent the wafer cassettes and the wafers stored therein from shifting while the pod or enclosure is moving, a mechanism need be provided to firmly hold the wafer cassettes. Conventional mechanism, however, may sometimes damage the wafers due to large manufacturing tolerance of the mechanism.

While accessing wafers from or into a conventional wafer cassette, the front end of a robotic hand usually bounces as the front end of the robotic hand unexpectedly hits the wall of the wafer cassette due to misalignment.

WO 2014/189739 discloses a front opening unified pod (FOUP) cassette container that includes a container housing. A wafer cassette housing that includes at least one cavity for positioning a wafer cassette is movably attached to the container housing so that the wafer cassette housing moves relative to a surface of the container housing to allow wafers cassettes to be loaded and removed. JP 2908161 discloses a cassette magazine where a plurality of wafers are housed and placed in a cassette magazine at certain positions respectively. The cassette magazine is composed of a stationary base plate, a rotary table provided onto the stationary base plate 1 in a rotatable manner, a plurality of cassette shelves provided onto the rotary table in such a manner that the shelves are movable, and a cover provided in a detachable manner covering the cassette shelves provided onto the rotary table. JP 5967919 discloses a transportation container. When an operator carries a transportation container by holding a first handle integrated with a box and a second handle integrated with a lid together, an engaging lever is automatically engaged with an engaging claw to close the transportation container.

For the reasons, a need has thus arisen to propose a novel apparatus for carrying and shielding wafers to overcome disadvantages of the conventional pods or enclosures.

### SUMMARY OF THE INVENTION

In view of the foregoing, it is an object of the embodiment of the present invention to provide apparatus for carrying and shielding wafers with high operational precision, without damaging wafers or bouncing the wall of the wafer cassette.

According to one embodiment, apparatus for carrying and shielding wafers includes a wafer container, a plurality of wafer cassettes and an engaging lock. The wafer cassettes are disposed in the wafer container. The engaging lock prevents the wafer cassettes from shifting forward, and the engaging lock is in direct contact with front surfaces of walls of the wafer cassettes.

According to another embodiment, apparatus for carrying and shielding wafers includes a wafer container and a plurality of wafer cassettes. The wafer cassettes are disposed in the wafer container, and are disposed on all sides of the container.

### BRIEF DESCRIPTION OF THE DRAWINGS

FIG. 1 shows a perspective view of apparatus for carrying and shielding wafers according to one embodiment of the present invention;
FIG. 2A shows a top view of an engaging lock of the apparatus of FIG 1 according to one embodiment of the present invention;
FIG. 2B shows a perspective view of the engaging lock of FIG. 2A;
FIG. 3A shows a top view illustrating a portion of the apparatus of FIG. 1 according to one embodiment of the present invention; and
FIG. 3B shows a perspective view of the partial apparatus in FIG. 3A.

### DETAILED DESCRIPTION OF THE INVENTION

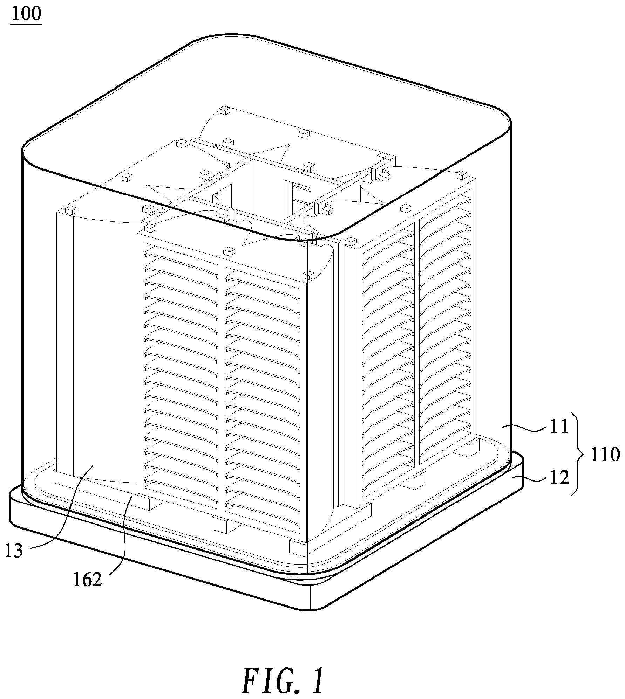

FIG. 1 shows a perspective view of apparatus 100 for carrying and shielding wafers, such as optical components (e.g., optical lenses or glasses), according to one embodiment of the present invention. In the embodiment, the apparatus 100 may include a wafer container 110, which primarily includes a cover 11 and a base 12. The cover 11 and the base 12 define a space for accommodating wafers. The cover 11 is preferably made of a transparent material (e.g., plastic) such that the wafers stored in the wafer container 110 may be readily inspected. One purpose of the wafer container 110 is to isolate the wafers from contamination by providing a mini environment. The wafer container 110 is designed to hold wafers securely and safely in a controlled environment, and to allow the wafers to be transferred between machines for processing or measurement.

In one embodiment, the wafer container 110 complies with Standard Mechanical InterFace (SMIF) standard. In another embodiment, the wafer container 110 complies with Front Opening Unified Pod (FOUP) standard. It is noted that the wafer container 110 of the embodiment may adopt standards other than SMIF and FOUP.

The apparatus 100 of the embodiment may include a plurality of wafer cassettes 13 disposed on the base 12 and enclosed in the cover 11. According one aspect of the embodiment, wafer cassettes 13 are disposed on all sides (four in this case) of the container 110. In the embodiment, at least two columns of wafer cassettes 13 are disposed on each side of the wafer container 110. The at least two columns of wafer cassettes 13 on the same side stand side by side, and have their openings facing outward. Accordingly, when the wafers on one side have been accessed by a robotic arm of a robot system, the base 12 is rotated and the wafers on other side may then be accessed by the robotic arm. In one embodiment, the at least two columns of wafer cassettes 13 on the same side are integrally formed as a single piece. According to another aspect of the embodiment, all columns of wafer cassettes 13 may be integrated as a single unit that can be wholly transferred into or from the wafer container 110. For example, top ends and bottom ends of all columns of wafer cassettes 13 may be pivotally connected to a top plate 161 and a bottom plate 162, respectively, thereby fixing all columns of wafer cassettes 13 together. Moreover, the integrated wafer cassettes 13 have the benefit of higher operational precision than the wafer cassettes that are isolated from each other, or are individually disposed.

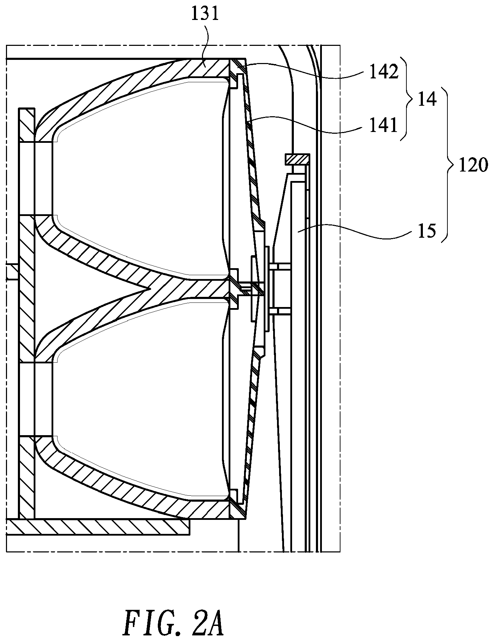

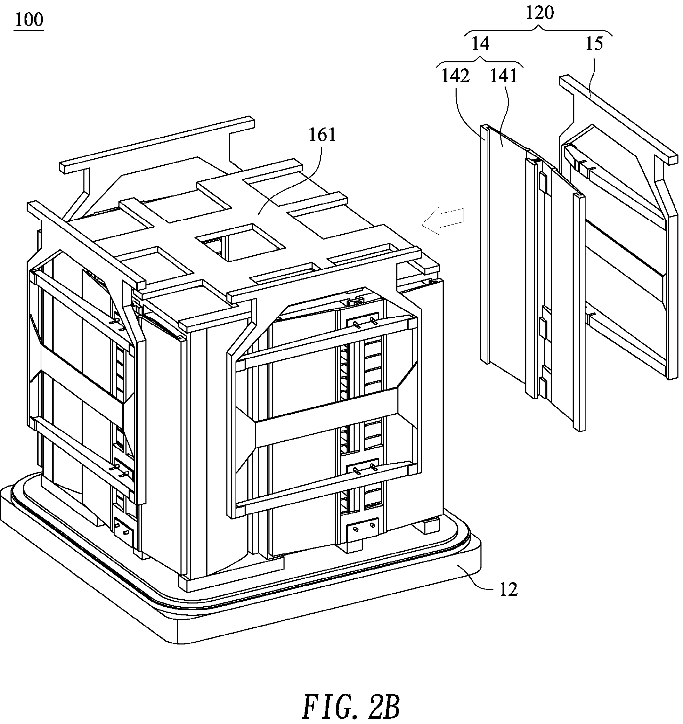

FIG. 2A shows a top view of an engaging lock 120 of the apparatus 100 of FIG. 1 adaptable for preventing the wafer cassettes 13 from shifting while the wafer container 110 with the wafer cassettes 13 is moving according to one embodiment of the present invention. FIG. 2B shows a perspective view of the engaging lock 120 of FIG. 2A. In the embodiment, the engaging lock 120 may include a dome 141 with elongated strips 142 fixedly disposed in vertical direction on an inner surface of the dome 141. In one embodiment, the dome 141 and the elongated strips 142 may be integrally formed as a single piece. In another embodiment, the dome 141 and the elongated strips 142 may be integrated into a single unit.

According to another aspect of the embodiment, the elongated strips 142 are designed to be in direct contact with walls 131, but not the wafers, of the wafer cassettes 13. In one embodiment, the length in a crosswise direction of the dome 141 may be designed to adjust the elongated strips 142 to be in direct contact with walls 131 of the wafer cassettes 13.

The engaging lock 120 of the embodiment may also include a bracket 15. The bracket 15 has an inner surface fixed on an outer surface of the dome 141, and has an outer surface fixed on an inner surface of the cover 11. Accordingly, when the cover 11 is placed over the wafer cassettes 13, the engaging lock 120 exerts pressure on the walls 131 of the wafer cassettes 13 to firmly hold the wafer cassettes 13 such that no movement between the wafer cassettes 13 and the cover 11 can occur, thereby securely preventing the wafer cassettes 13 from shifting while the wafer container 110 is moving. The benefit of designing the elongated strips 142 of the embodiment to be in direct contact with walls 131, but not the wafers, of the wafer cassettes 13 is that the wafers will not be damaged by the elongated strips 142 in case the manufacturing tolerance of the elongated strips 142 is large. In one embodiment, as shown in FIG. 2A, each elongated strip 142 has one-side or two-side horizontal extensions in a crosswise direction of the wafer cassettes 13, and the extensions are configured to prevent the wafers from slipping away from the wafer cassettes 13. In the embodiment, the dome 141, the elongated strips 142 and the bracket 15 may be made of a metallic material.

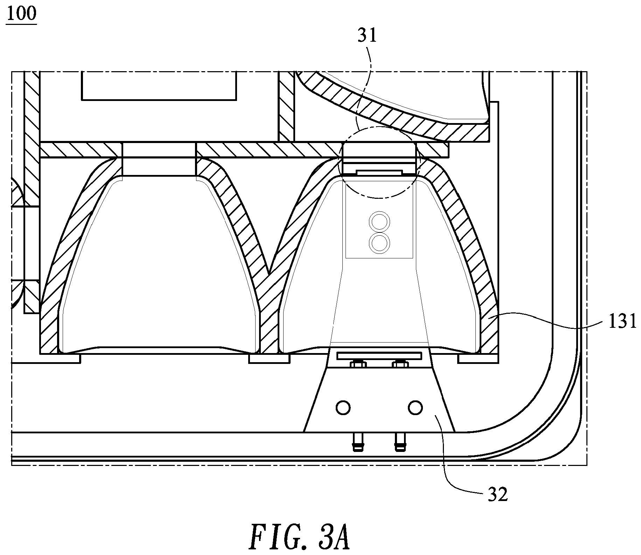

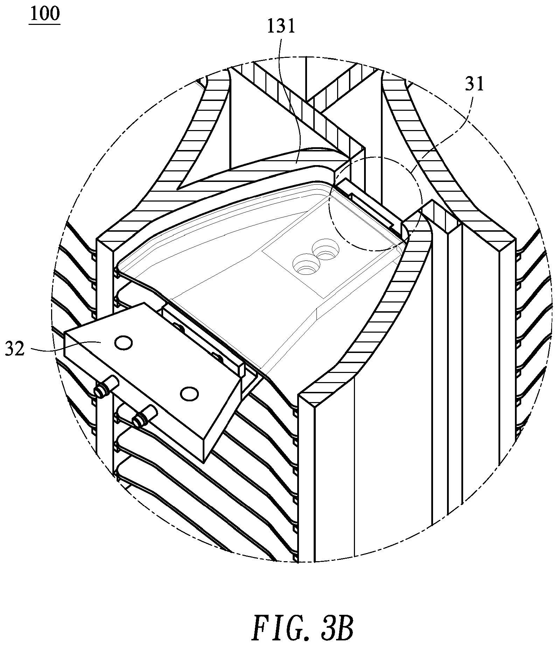

FIG. 3A shows a top view illustrating a portion of the apparatus 100 according to one embodiment of the present invention. FIG. 3B shows a perspective view of the partial apparatus 100 in FIG. 3A. According to a further aspect of the embodiment, a distal end 31 of the wafer cassette 13 is unblocked. In other words, the distal end 31 of the wafer cassette 13 has an opening at the distal end 31. The benefit of designing the wafer cassette 13 with an opening at the distal end 31 is that a front end of a robotic hand 32 will not bounce in case that the front end of the robotic hand 32 unexpectedly hits the wall 131 of the wafer cassette 13 due to misalignment.

Although specific embodiments have been illustrated and described, it will be appreciated by those skilled in the art that various modifications may be made without departing from the scope of the present invention, which is defined by the appended claims.

## Claims

1. Apparatus (100) for carrying and shielding wafers in a horizontal orientation, comprising:
a wafer container (110);
a plurality of wafer cassettes (13) disposed in the wafer container; **characterized in that** the apparatus comprises:
an engaging lock (120) that prevents the wafer cassettes from shifting toward the engaging lock, the engaging lock being in direct contact with surfaces of walls (131) of the wafer cassettes that face the engaging lock.

2. The apparatus of claim 1, wherein the engaging lock is not in contact with the wafers.

3. The apparatus of claim 1, wherein the engaging lock comprises:
a dome (141) with elongated strips (142) fixedly disposed in vertical direction on an inner surface of the dome, the elongated strips being in direct contact with the surfaces of the walls of the wafer cassettes that face the engaging lock; and
a bracket (15) having an inner surface fixed on an outer surface of the dome, and having an outer surface fixed on an inner surface of the wafer container.

4. The apparatus of claim 3, wherein each of the elongated strips has one-side or two-side horizontal extensions that prevent the wafers from slipping toward the engaging lock.

5. The apparatus of claim 1, wherein the wafer container comprises a cover (11) and a base (12), which define a space for accommodating the wafers.

6. The apparatus of claim 5, wherein the cover is made of a transparent material.

7. The apparatus of claim 1, wherein the wafer container complies with Standard Mechanical InterFace standard or Front Opening Unified Pod standard.

8. The apparatus of claim 1, wherein a distal end of the wafer cassette has an opening such that a distal end (31) of the wafer cassette is unblocked.

## Patentansprüche

1. Vorrichtung (100) zum Tragen und Abschirmen von Wafern in einer waagerechten Ausrichtung, aufweisend
einen Waferbehälter (110);
mehrere Waferkassetten (13), die in dem Waferbehälter angeordnet sind; **dadurch gekennzeichnet, dass** die Vorrichtung
einen eingreifenden Verschluss (120) aufweist, der verhindert, dass sich die Waferkassetten zu dem eingreifenden Verschluss hin verschieben, wobei der eingreifende Verschluss in einem direkten Kontakt mit Oberflächen von Wänden (131) der Waferkassetten, die zu dem eingreifenden Verschluss gewandt sind, steht.

2. Vorrichtung nach Anspruch 1, wobei der eingreifende Verschluss nicht mit den Wafern in Kontakt steht.

3. Vorrichtung nach Anspruch 1, wobei der eingreifende Verschluss
eine Wölbung (141) mit langgestreckten Streifen (142), die fest in der senkrechten Richtung an einer Innenfläche der Wölbung angeordnet sind, wobei die langgestreckten Streifen in einem direkten Kontakt mit den Oberflächen der Wände der Waferkassetten, die zu dem eingreifenden Verschluss gewandt sind, stehen; und
eine Halteklammer (15) mit einer an einer Außenfläche der Wölbung fixierten Innenfläche und mit einer an einer Innenfläche des Waferbehälters fixierten Außenfläche
aufweist.

4. Vorrichtung nach Anspruch 3, wobei jeder der langgestreckten Streifen an einer Seite oder an beiden Seiten waagerechte Verlängerungen aufweist, die verhindern, dass die Wafer zu dem eingreifenden Verschluss hin gleiten.

5. Vorrichtung nach Anspruch 1, wobei der Waferbehälter eine Abdeckung (11) und eine Basis (12) aufweist, die einen Raum zur Unterbringung der Wafer definieren.

6. Vorrichtung nach Anspruch 5, wobei die Abdeckung aus einem durchsichtigen Material hergestellt ist.

7. Vorrichtung nach Anspruch 1, wobei der Waferbehälter dem Standard-Mechanical-InterFace-Standard oder dem Front-Opening-Unified-Pod-Standard entspricht.

8. Vorrichtung nach Anspruch 1, wobei ein distales Ende der Waferkassette eine Öffnung aufweist, so dass ein distales Ende (31) der Waferkassette nicht versperrt ist.

## Revendications

1. Appareil (100) pour transporter et protéger des plaquettes dans une orientation horizontale, comprenant :
un conteneur de plaquettes (110);
une pluralité de cassettes de plaquettes (13) disposées dans le conteneur de plaquettes ; **caractérisé en ce que** l'appareil comprend :
un verrou de mise en prise (120) qui empêche les cassettes de plaquettes de se déplacer vers le verrou de mise en prise, le verrou de mise en prise étant en contact direct avec les surfaces des parois (131) des cassettes de plaquettes qui font face au verrou de mise en prise .

2. Appareil selon la revendication 1, dans lequel le verrou de mise en prise n'est pas en contact avec les plaquettes.

3. Appareil selon la revendication 1, dans lequel le verrou de mise en prise comprend :
un dôme (141) à lamelles allongées (142) disposées fixement dans une direction verticale sur une surface intérieure du dôme, les lamelles allongées étant en contact direct avec les surfaces des parois des cassettes de plaquettes qui font face au verrou de mise en prise ; et
un support (15) ayant une surface intérieure fixée sur une surface extérieure du dôme, et ayant une surface extérieure fixée sur une surface intérieure du conteneur de plaquettes.

4. Appareil selon la revendication 3, dans lequel chacune des lamelles allongées possède des extensions horizontales sur un ou deux côtés qui empêchent les plaquettes de glisser vers le verrou de mise en prise.

5. Appareil selon la revendication 1, dans lequel le conteneur de plaquettes comprend un couvercle (11) et une base (12), qui définissent un espace pour renfermer les plaquettes.

6. Appareil selon la revendication 5, dans lequel le couvercle est réalisé en un matériau transparent.

7. Appareil selon la revendication 1, dans lequel le conteneur de plaquettes est conforme à la norme Standard Mechanical InterFace ou à la norme Front Opening Unified Pod.

8. Appareil selon la revendication 1, dans lequel une extrémité distale de la cassette de plaquettes présente une ouverture telle qu'une extrémité distale (31) de la cassette de plaquette soit débloquée.
